(19) **Europäisches Patentamt / European Patent Office / Office européen des brevets**

(11) **EP 2 284 901 A1**

(12) **EUROPEAN PATENT APPLICATION**
published in accordance with Art. 153(4) EPC

(43) Date of publication:
**16.02.2011 Bulletin 2011/07**

(21) Application number: **09738699.9**

(22) Date of filing: **10.04.2009**

(51) Int Cl.:
**H01L 29/786** *(2006.01)*  **H01L 21/8238** *(2006.01)*
**H01L 27/08** *(2006.01)*  **H01L 27/092** *(2006.01)*

(86) International application number:
**PCT/JP2009/057310**

(87) International publication number:
**WO 2009/133762 (05.11.2009 Gazette 2009/45)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **28.04.2008 JP 2008116701**

(71) Applicants:
• **National University Corporation Tohoku University**
  **Sendai-shi**
  **Miyagi 980-8577 (JP)**
• **Foundation for Advancement of International Science**
  **Tsukuba-shi, Ibaraki 305-0062 (JP)**

(72) Inventors:
• **OHMI, Tadahiro**
  **Sendai-shi**
  **Miyagi 980-8577 (JP)**
• **TERAMOTO, Akinobu**
  **Sendai-shi**
  **Miyagi 980-8577 (JP)**
• **KURODA, Rihito**
  **Sendai-shi**
  **Miyagi 981-0944 (JP)**

(74) Representative: **Glawe, Delfs, Moll**
  **Patent- und Rechtsanwälte**
  **Postfach 26 01 62**
  **80058 München (DE)**

(54) **SEMICONDUCTOR DEVICE**

(57)    With inversion-mode transistors, intrinsic-mode transistors, or semiconductor-layer accumulation-layer current controlled accumulation-mode transistors, variation in threshold voltages becomes large in miniaturized generations due to statistical variation in impurity atom concentrations and thus it is difficult to maintain the reliability of an LSI. Provided is a bulk current controlled accumulation-mode transistor which is formed by controlling the thickness and the impurity atom concentration of a semiconductor layer so that the thickness of a depletion layer becomes greater than that of the semiconductor layer. For example, by setting the thickness of the semiconductor layer to 100nm and setting the impurity concentration thereof to be higher than $2 \times 10^{17}$ [cm$^{-3}$], the standard deviation of variation in threshold values can be made smaller than a power supply voltage-based allowable variation value.

FIG. 3

EP 2 284 901 A1

**Description**

Technical Field

This invention relates to a semiconductor device such as an IC or an LSI.

Background Art

Conventionally, inversion-mode transistors of the type that forms an inversion layer in a channel region have been widely used in semiconductor devices such as ICs and LSIs. In this transistor, it is necessary to increase the impurity atom concentration in the channel region in order to suppress a short channel effect whose influence increases with the structural miniaturization of the transistor. On the other hand, variation in threshold values of the transistors is due to variation in impurity atom concentrations in the channel regions. Further, the variation in threshold values of the transistors is approximately inversely proportional to the square root of the channel area. For these reasons, there has been a problem that, with the inversion-mode transistors, it is not possible to suppress the variation in threshold values of the transistors attendant upon the structural miniaturization thereof and thus it is not possible to ensure the reliability of an LSI.

For example, it is pointed out that, in order to operate an LSI comprising a trillion ($10^{12}$) transistors so that no malfunction occurs at all for 10 years at a clock rate of 10GHz, the power supply voltage and the threshold voltage should satisfy the relationship of the following formula (1) (Non-Patent Document 1).

[Formula 1]

$$V_{DD} > 23 \cdot \sigma_{Vth} \qquad (1)$$

where $V_{DD}$ is a power supply voltage of the LSI and $\sigma_{Vth}$ a standard deviation of variation in threshold values.

As is also clear from the formula (1), it is effective to increase the power supply voltage in order to suppress malfunction of the LSI due to variation in threshold values. However, in consideration of the reliability of a gate insulating film of each transistor, the absolute value of an electric field that can be applied to the gate insulating film is determined to be, for example, 8MV/cm or the like. As a result, the power supply voltage applied to a gate electrode should be reduced with the miniaturization of the gate insulating film that is reduced in thickness with the structural miniaturization and thus the variation in threshold values should be more suppressed with the miniaturization.

On the other hand, in the doping technique and the impurity activation technique that are necessary for allowing a semiconductor to have a function as an n-type semiconductor or a p-type semiconductor, it is known that when the average number of finally activated impurity atoms per region is n and when there are a large number of such regions, statistical variation according to a normal distribution with a standard deviation of $\sqrt{n}$, i.e. the square root of the average number, occurs in the numbers of the impurity atoms contained in those regions.

In the case of an inversion-mode transistor using a bulk semiconductor, a threshold value $V_{th}$ of the transistor is generally given by the following formula (2).

[Formula 2]

$$V_{th} = V_{fb} + 2\phi_B + \frac{\sqrt{2\varepsilon_{si} q N_A (2\phi_B)}}{C_{ox}} \qquad (2)$$

where $\varepsilon_{si}$ [F/cm] is a permittivity of silicon, q [C] an elementary charge, $N_A$ [cm$^{-3}$] an acceptor-type impurity atom concentration in a channel region, and $C_{ox}$ [F/cm$^2$] a capacitance of a gate insulating film. Further, $V_{fb}$ [V] is a flatband voltage and $\phi_B$ [V] a potential difference from an intermediate energy level in a band gap to a Fermi level in the silicon.

The formula (2) represents a formula of a threshold value of an n-channel inversion-mode transistor while, in the case of a p-channel inversion-mode transistor, $N_D$ [cm$^{-3}$] being a donor-type impurity atom concentration is used for $N_A$.

$V_{fb}$ and $\phi_B$ are given by the following formulas (3) and (4), respectively.

[Formula 3]

$$V_{fb} = \phi_m - \chi_{si} - \frac{E_g}{2} - \phi_B + \frac{Q_f}{C_{ox}} \qquad (3)$$

[Formula 4]

$$\phi_B = \frac{kT}{q} \ln\left(\frac{N_A}{n_i}\right) \qquad (4)$$

where $\phi_m$ is a work function of a gate electrode, $X_{si}$ an electron affinity of the silicon, and $E_g$ the band gap of the silicon, all of which are given in unit of [V]. $Q_f$ is a charge density [C/cm²] assuming that charges contained in the gate insulating film are present in the interface between the silicon and the gate insulating film. In the formula (4), $n_i$ is an intrinsic carrier density [cm⁻³].

As seen from the formulas (2) to (4), the threshold value of the inversion-mode transistor is a function of the impurity atom concentration in the channel region.

Herein, assuming that the average impurity atom concentration per channel region is $N_A$ [cm⁻³], the average number of impurity atoms contained in the channel region can be expressed by the following formula (5).

[Formula 5]

$$n_{channel} = N_A \cdot L_{eff} \cdot W_{eff} \cdot W_{dep} \qquad (5)$$

where $n_{channel}$ is the average number [atoms] of the impurity atoms contained in the channel region, $L_{eff}$ an effective channel length [cm], $W_{eff}$ an effective channel width [cm], and $W_{dep}$ a maximum depletion layer width [cm]. Therefore, the impurity atom concentration in the channel when varied due to an increase or decrease in the number of the impurity atoms corresponding to a standard deviation is expressed by the following formula (6) or (7).

[Formula 6]

$$N_A^+ = \left(n_{channel} + \sqrt{n_{channel}}\right) / \left(L_{eff} \cdot W_{eff} \cdot W_{dep}\right) \qquad (6)$$

[Formula 7]

$$N_A^- = \left(n_{channel} - \sqrt{n_{channel}}\right) / \left(L_{eff} \cdot W_{eff} \cdot W_{dep}\right) \qquad (7)$$

where $N_A^+$ is the impurity atom concentration [cm⁻³] when the number of the impurity atoms is increased corresponding to the standard deviation while $N_A^-$ is the impurity atom concentration [cm⁻³] when the number of the impurity atoms is decreased corresponding to the standard deviation. Assuming that the threshold values when the impurity atom concentrations in the channel regions are $N_A^+$ and $N_A^-$ are given by $V_{th}(N_A^+)$ and $V_{th}(N_A^-)$, respectively, the standard deviation of variation in threshold values is given by the following formula (8).

[Formula 8]

$$\sigma_{Vth} = \left( V_{th}\left( N_A{}^+ \right) - V_{th}\left( N_A{}^+ \right) \right)/2 \qquad (8)$$

Table 1 shows, with respect to the gate length L of each of the transistor miniaturized generations, the effective channel length, the power supply voltage of inversion-mode transistors, the electrical equivalent oxide thickness (EOT), the average threshold value, the allowable value of variation in threshold values given by the formula (1), $N_A$, $n_{channel}$, $\sqrt{n_{channel}}$, $n_{channel}+\sqrt{n_{channel}}$, $n_{channel}-\sqrt{n_{channel}}$, $N_A{}^+$, $N_A{}^-$, and the standard deviation of variation in threshold values generated by variation in impurity atom concentrations.

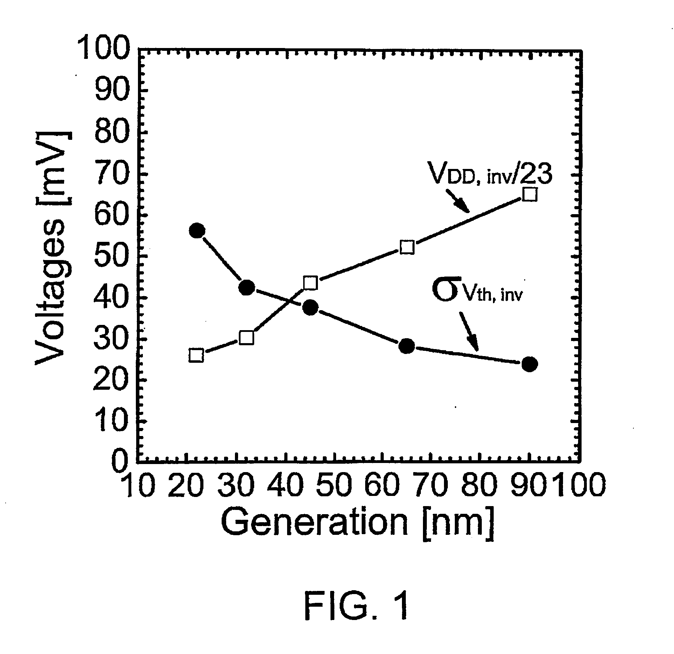

Referring to Fig. 1, there are shown, with respect to each of the transistor miniaturized generations, an allowable value ($\sigma=V_{DD, inv}/23$) of variation in threshold values given by the formula (1) and a standard deviation $\sigma_{Vth, inv}$ of variation in threshold values generated by variation in impurity atom concentrations in the inversion-mode transistors. Herein, the power supply voltage of the inversion-mode transistors is set to a value such that the strength of an electric field applied to a gate insulating film of each inversion-mode transistor does not exceed 8MV/cm. A value of the effective channel width $W_{eff}$ is equal to that of each of the miniaturized generations L.

[Table 1]

| Generation L [nm] | 90 | 65 | 45 | 32 | 22 |
|---|---|---|---|---|---|
| $L_{eff}$ [nm] | 50 | 41 | 29 | 20 | 12 |
| $V_{DD.inv}$ [V] | 1.5 | 1.2 | 1.0 | 0.7 | 0.6 |
| EOT [nm] | 1.5 | 1.2 | 1.0 | 0.7 | 0.5 |
| $V_{th.inv}$ [V] | 0.30 | 0.30 | 0.30 | 0.25 | 0.25 |
| Allowable Variation Value: $\sigma = V_{DD.inv}/23$ [mV] | **65.2** | **52.2** | **43.5** | **30.4** | **26.1** |
| $N_A$ [cm$^{-3}$] | $1.1\times10^{18}$ | $2.1\times10^{18}$ | $3.1\times10^{18}$ | $4.1\times10^{18}$ | $5.0\times10^{18}$ |
| Number of Impurity Atoms: $n_{ch}$ | 165.6 | 137.9 | 82.9 | 47.1 | 21.6 |
| Variation in Numbers of Impurity Atoms: $\sqrt{n}$ | 12.9 | 11.7 | 9.1 | 6.9 | 4.6 |
| $n+\sqrt{n}$ | 178.5 | 149.7 | 92.0 | 54.0 | 26.2 |
| $n-\sqrt{n}$ | 152.7 | 126.2 | 73.8 | 40.2 | 16.9 |
| $N_A{}^+$ [cm$^{-3}$] | $1.3\times10^{18}$ | $2.5\times10^{18}$ | $3.8\times10^{18}$ | $5.3\times10^{18}$ | $7.3\times10^{18}$ |
| $N_A{}^-$ [cm$^{-3}$] | $9.4\times10^{17}$ | $1.8\times10^{18}$ | $2.6\times10^{18}$ | $3.0\times10^{18}$ | $2.9\times10^{18}$ |
| $\sigma_{Vth.inv}$ [mV] | **23.9** | **28.3** | **37.6** | **42.4** | **56.2** |

As seen from Table 1 and Fig. 1, with the inversion-mode transistors, in the generation after the 45nm generation, i.e. in the generation miniaturized more than 45nm (i.e. in the 30nm or 20nm miniaturized generation), the standard deviation $\sigma_{Vth}$ (herein, given by $\sigma_{Vtn, inv}$ because of the inversion-mode transistors) exceeds the allowable value $V_{DD}/23$ (i.e. $V_{DD, inv}/23$) of variation in threshold values and therefore it is not possible to satisfy a performance requirement that an LSI comprising a trillion transistors does not malfunction at all for 10 years at a clock rate of 10GHz, due to variation in impurity atom concentrations in channel regions.

On the other hand, in the case of intrinsic-mode transistors in which the average impurity atom concentration per channel region is 0 [cm$^{-3}$], it is not possible to satisfy the performance requirement due to variation in threshold values caused by the imperfection of the silicon wafer impurity control technique.

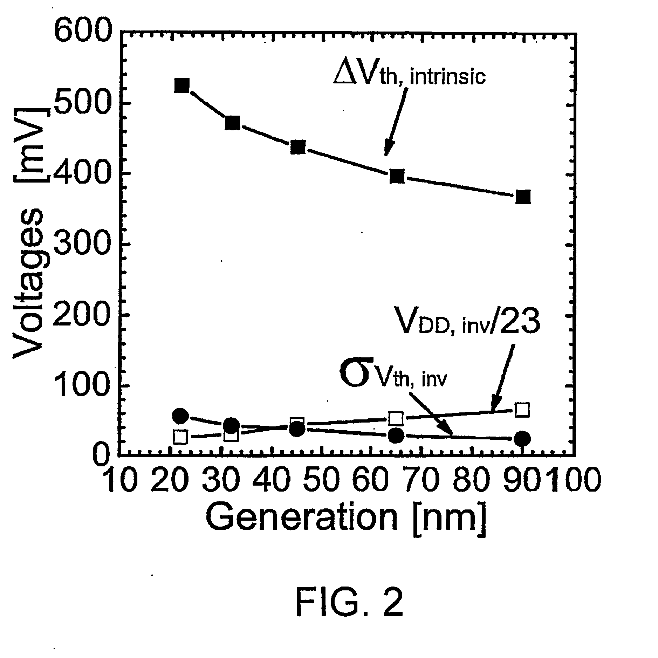

The intrinsic-mode transistor will be described in more detail. Even if the impurity atom concentration in a silicon wafer is thoroughly suppressed, if there are a large number of transistors, there is a possibility of appearance of the transistor having one impurity atom in its channel region. In this case, a threshold value difference $\Delta V_{th, intrinsic}$ between the transistor having no impurity atom in its channel region and the transistor having one impurity atom in its channel region becomes as shown in Table 2 and Fig. 2 with respect to each of the miniaturized generations. In any of the generations, the threshold value difference $\Delta V_{th, intrinsic}$ between the transistor having no impurity atom in its channel region and the transistor having one impurity atom in its channel region largely exceeds 1/23 of a power supply voltage

($V_{DD, intrinsic}$) of the intrinsic-mode transistors and, therefore, if even one of the transistors forming an LSI has one impurity atom in its channel region, the LSI malfunctions.

[Table 2]

| Generation L [nm] | 90 | 65 | 45 | 32 | 22 |
|---|---|---|---|---|---|
| $L_{eff}$ [nm] | 50 | 41 | 29 | 20 | 12 |
| $V_{DD.intrinsic}$ [V] | 1.5 | 1.2 | 1.0 | 0.7 | 0.6 |
| EOT [nm] | 1.5 | 1.2 | 1.0 | 0.7 | 0.5 |
| $T_{SOI}$ [nm] | 23.0 | 16.0 | 11.0 | 8.0 | 5.5 |
| $V_{th}$ [V] | 0.30 | 0.30 | 0.30 | 0.25 | 0.25 |
| Allowable Variation Value: $\sigma = V_{DD.intrinsic}/23$ [mV] | **65.2** | **52.2** | **43.5** | **30.4** | **26.1** |
| Channel Volume [$cm^3$] | $1.0 \times 10^{-16}$ | $4.3 \times 10^{-17}$ | $1.4 \times 10^{-17}$ | $5.1 \times 10^{-18}$ | $1.5 \times 10^{-18}$ |
| Density in case of One Impurity Atom [$cm^{-3}$] | $9.7 \times 10^{15}$ | $2.3 \times 10^{16}$ | $7.0 \times 10^{16}$ | $2.0 \times 10^{17}$ | $6.9 \times 10^{17}$ |
| $\Delta V_{th.intrinsic}$ [mV] | **367.6** | **396.5** | **437.7** | **472.7** | **524.1** |

When transistors are fabricated with the maximum density in an LSI chip having a chip area of 4.0cm², the sum total of channel regions of the transistors in the chip becomes 0.286cm². Table 3 shows the number of transistors which are included in a chip of each of the miniaturized generations and each of which has one impurity atom in its channel region to cause malfunction of the LSI, when use is made of a silicon wafer with the total concentration of n-type and p-type impurity atoms being $10^{13}$ to $10^6 cm^{-3}$. Herein, it is necessary to use an SOI (Silicon on Insulator) structure in the intrinsic-mode transistor in order to realize normally-off and the thickness of an SOI layer is set to 1/4 of the effective channel length in order to sufficiently suppress a short channel effect. The impurity atom concentration in a silicon wafer currently practical is on the order of at least $10^{12} cm^{-3}$ and thus it is impossible to suppress the number of transistors, which cause malfunction of an LSI, to 1 or less.

[Table 3]

| Generation L [nm] | 90 | 65 | 45 | 32 | 22 |
|---|---|---|---|---|---|
| $L_{eff}$ [nm] | 50 | 41 | 29 | 20 | 12 |
| Number of Devices in Chip: Ntot | $6.17 \times 10^9$ | $1.18 \times 10^{10}$ | $2.47 \times 10^{10}$ | $4.88 \times 10^{10}$ | $1.03 \times 10^{11}$ |
| Total Volume of Channels in Chip [$cm^{-3}$] | $6.39 \times 10^{-7}$ | $5.05 \times 10^{-7}$ | $3.54 \times 10^{-7}$ | $2.50 \times 10^{-7}$ | $1.50 \times 10^{-7}$ |
| Wafer Impurity Density $1 \times 10^{13}$ [$cm^{-3}$], Number of Failure Causing Devices | $6.39 \times 10^6$ | $5.05 \times 10^6$ | $3.54 \times 10^6$ | $2.50 \times 10^6$ | $1.50 \times 10^6$ |
| Wafer Impurity Density $1 \times 10^{11}$ [$cm^{-3}$], Number of Failure Causing Devices | $6.39 \times 10^3$ | $5.05 \times 10^3$ | $3.54 \times 10^3$ | $2.50 \times 10^3$ | $1.50 \times 10^3$ |
| Wafer Impurity Density $1 \times 10^{13}$ [$cm^{-3}$], Ratio of Failure Causing Devices | $1.04 \times 10^{-3}$ | $4.26 \times 10^{-4}$ | $1.44 \times 10^{-4}$ | $5.12 \times 10^{-5}$ | $1.45 \times 10^{-5}$ |
| Wafer Impurity Density $1 \times 10^{11}$ [$cm^{-3}$], Ratio of Failure Causing Devices | $1.04 \times 10^{-6}$ | $4.26 \times 10^{-7}$ | $1.44 \times 10^{-7}$ | $5.12 \times 10^{-8}$ | $1.45 \times 10^{-8}$ |

Prior Art Document

Patent Document

Patent Document 1: WO2008/007749A1

Non-Patent Document

Non-Patent Document 1: T. Ohmi, M. Hirayama, and A. Teramoto, "New era of silicon technologies due to radical reaction based semiconductor manufacturing", J. Phys., D, Appl. Phys. vol. 39 pp. R1-R17, 2006

Summary of the Invention

Problem to be Solved by the Invention

The present inventors have proposed, in Patent Document 1, an accumulation-mode transistor in which the gate voltage can be set high. However, it has been found that, even with such accumulation-mode transistors, a requirement for variation in threshold values cannot be satisfied in the 32nm or less miniaturized generation.

This will be described in detail. In the case of the accumulation-mode transistor, as described in Patent Document 1, current components flowing in a channel region can be divided into a current component ($I_{acc}$ [A]) flowing in an accumulation layer in the vicinity of the interface between a gate insulating film and silicon and a current component ($I_{bulk}$ [A]) flowing in a region, other than the accumulation layer, of the channel region.

According to the gradual channel approximation, the relationship between a drain current ($I_D$ [A]) and a gate voltage ($V_g$ [V]) can be expressed by the following formulas (9), (10), and (11) in ranges where the gate voltage is relatively small. Herein, $V_{fb}$ [V] is a flatband voltage, $W_{dep}$ [cm] a width of a silicon depletion layer, $T_{SOI}$ [cm] a thickness of an SOI layer, and $N_{SOI}$ an impurity atom concentration in the SOI layer.

[Formula 9]

Range 1:     $(V_g - V_{fb}) < 0$ and $W_{dep} > T_{SOI}$

$$I_D \approx I_{bulk} = \frac{qW_{eff}}{L} D_{nbulk} \int_0^{T_{SOI}} N_{SOI} \exp^{-\beta\phi(x)} \left(1 - \exp^{-\beta V_D}\right) \exp^{-\beta(V_{T_{SOI}} - (V_g - V_{fb}))} dx$$

$$(9)$$

[Formula 10]

Range 2:     $(V_g - V_{fb}) < 0$ and $W_{dep} < T_{SOI}$

$$I_D \approx I_{bulk} = \frac{qW_{eff}}{L} D_{nbulk} \int_0^{W_{dep}} N_{SOI} e^{-\beta\phi(x)} \left(1 - e^{-\beta V_D}\right) dx + \frac{qW_{eff}}{L} D_{nbulk} N_{SOI} \left(T_{SOI} - W_{dep}\right)$$

$$(10)$$

[Formula 11]

Range 3:     $(V_g - V_{fb}) > 0$

$$I_D = I_{Acc} + I_{bulk} = q W T_{acc} D_{nacc} \frac{n_{acc}(0) - n_{acc}(L)}{L} + \frac{qW}{L} D_{nbulk} N_{SOI} \left( T_{SOI} - W_{Dep} \right)$$

(11)

where $D_{nbulk}$ [cm²/s] is a diffusion coefficient of electrons in a region, other than the vicinity of the interface between a gate insulating film and silicon, of a channel region, $N_{SOI}$ [cm⁻³] an impurity atom concentration in an SOI layer, β [V⁻¹] a reciprocal of thermal energy, φ(x) [V] a potential displacement from a Fermi level of bulk silicon with an impurity atom concentration of $N_{SOI}$ at a depth of distance x from the gate insulating film, $V_D$ [V] a drain voltage, $V_{TSOI}$ [V] $V_g$ when $W_{dep} = T_{SOL}$, $T_{acc}$ [cm] a width of an accumulation layer, $D_{nacc}$ [cm²/s] a diffusion coefficient of electrons in a region, in the vicinity of the interface between the gate insulating film and the silicon, of the channel region, and $n_{acc}$ (O) and $n_{acc}(L)$ [cm⁻³] are electron concentrations in the accumulation layer in the channel region at a source electrode end and a drain electrode end, respectively. The formulas (9) to (11) are given for an n-channel transistor, but can also be used for a p-channel transistor by changing the parameters such as $D_{nbulk}$ and $D_{nacc}$ to values for holes.

In the ranges 1 and 3 represented by the formulas (9) and (11), the drain current changes exponentially with respect to the gate voltage. This is because the term $\exp(-\beta(V_{TSOI} - (V_g - V_{fb})))$ of the formula (9) changes exponentially and the term $(n_{acc}(O) - n_{acc}(L)/L)$ of the formula (11) changes exponentially.

On the other hand, in the range 2 represented by the formula (10), the drain current that changes depending on $(T_{SOI} - W_{dep})$ is proportional to the square root of the gate voltage. Practically, it is desirable to set a threshold value in a range where the drain current changes exponentially with respect to the gate voltage. Therefore, herein, no examination is made of a transistor having a threshold voltage in the range 2.

Herein, in this invention, an accumulation-mode transistor having a threshold voltage in the range 1 is defined as a bulk current controlled ($I_{bulk}$ controlled) accumulation-mode transistor while an accumulation-mode transistor having a threshold voltage in the range 3 is defined as an accumulation current controlled ($I_{acc}$ controlled) accumulation-mode transistor.

At any rate, using the formulas (9) to (11), it can be clearly seen whether a device is a bulk current controlled ($I_{bulk}$ controlled) device, an accumulation current controlled ($I_{acc}$ controlled) device, or a device having a threshold voltage in the range 2, by a combination of the thickness $T_{SOI}$ and the impurity atom concentration $N_{SOI}$ of an SOI layer.

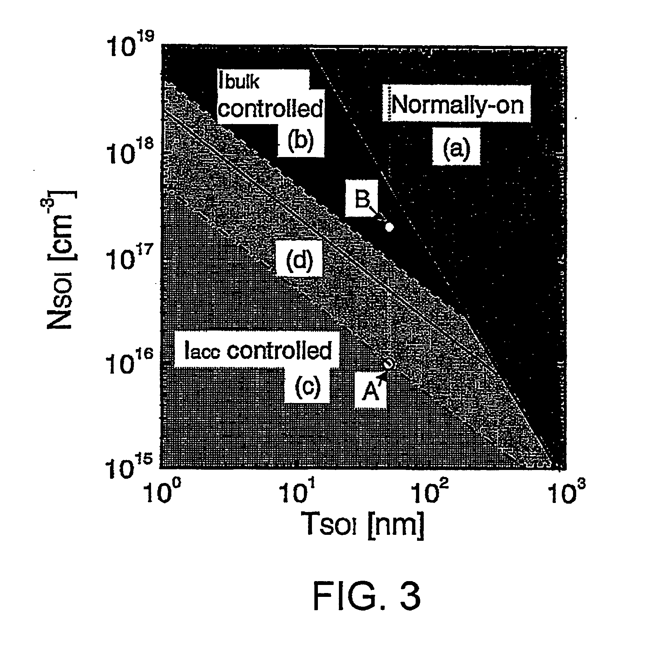

Referring to Fig. 3, the ordinate axis represents the SOI-layer impurity concentration $N_{SOI}$ (cm⁻³) while the abscissa axis represents the SOI-layer thickness $T_{SOI}$ (nm), wherein there are shown device ranges corresponding to combinations of $T_{SOI}$ and $N_{SOI}$. Herein, the threshold voltage is set to a gate voltage when a value ($I_D / (W/L)$) obtained by normalizing a drain current by the channel width and the channel length becomes 1μA which is generally defined as a threshold value of a circuit.

Fig. 3 is divided into four zones (a), (b), (c), and (d) corresponding to combinations of $T_{SOI}$ and $N_{SOI}$, wherein the zone (a) corresponds to a normally-on device, the zone (b) corresponds to the range 1 of a device represented by the formula (9) (i.e. a bulk current controlled ($I_{bulk}$ controlled) accumulation-mode transistor), and further the zone (c) corresponds to the range 3 of a device represented by the formula (11) (an accumulation current controlled ($I_{acc}$ controlled) accumulation-mode transistor). Further, the zone (d) corresponds to the range 2 of a device represented by the formula (10).

A conventionally well-known accumulation-mode transistor is an accumulation current controlled accumulation-mode transistor or a transistor having a threshold voltage in the range 2 which is practically difficult to use.

The accumulation current controlled accumulation-mode transistor will be described in more detail. The threshold voltage of the accumulation current controlled accumulation-mode transistor is a gate voltage when it is equal to $V_{fb}$, as shown by the following formula (12).

[Formula 12]

$$V_{th}=V_{fb}=\phi_m-\phi_{Si}+\frac{Q_f}{C_{ox}}=\phi_m-\left(4.05+1.12/2-\frac{kT}{q}ln\left(\frac{N_{SOI}}{n_i}\right)\right)+\frac{Q_f}{C_{ox}}$$

$$=\phi_m-4.61+\frac{Q_f}{C_{ox}}+\frac{kT}{q}ln\left(\frac{N_{SOI}}{n_i}\right)$$

(12)

Table 4 shows, with respect to each of the transistor miniaturized generations, the effective channel length ($L_{eff}$), the power supply voltage of accumulation current controlled accumulation-mode transistors, the electrical equivalent oxide thickness (EOT), the average threshold value, the allowable value of variation in threshold values of the accumulation current controlled accumulation-mode transistors given by the formula (12), $N_{SOL}$, $n_{channel}$, $\sqrt{n}_{channel}$, $n_{channel}+\sqrt{n}_{channel}$, $n_{channel}-\sqrt{n}_{channel}$, the SOI-layer impurity atom concentrations $N_{SOL}^+$ and $N_{SOL}^-$ when the number of impurity atoms is increased or decreased corresponding to a standard deviation, and the standard deviation of variation in threshold values generated by variation in impurity atom concentrations. The power supply voltage $V_{DD, lacc}$ of the accumulation current controlled accumulation-mode transistors is set to a value such that the strength of an electric field applied to a gate insulating film of each accumulation current controlled accumulation-mode transistor does not exceed 8MV/cm.
[Table 4]

| | 90 | 65 | 45 | 32 | 22 |
|---|---|---|---|---|---|
| Generation L [nm] | 90 | 65 | 45 | 32 | 22 |
| $L_{eff}$ [nm] | 50 | 41 | 29 | 20 | 12 |
| $V_{DD.inv}$ [V] | **1.50** | **1.20** | **1.00** | **0.70** | **0.60** |
| $V_{DD.lacc}$ [V] | **1.80** | **1.50** | **1.30** | **0.93** | **0.80** |
| EOT [nm] | 1.5 | 1.2 | 1.0 | 0.7 | 0.5 |
| $V_{th}$ [V] | 0.30 | 0.30 | 0.30 | 0.25 | 0.25 |
| Allowable Variation Value: $\sigma = V_{DD.inv}/23$ [mV] | **65.2** | **52.2** | **43.5** | **30.4** | **26.1** |
| Allowable Variation Value: $\sigma = V_{DD.lacc}/23$ [mV] | **78.3** | **65.2** | **56.5** | **40.4** | **34.8** |
| $N_{SOI}$ [cm$^{-3}$] | $2.3\times10^{16}$ | $3.1\times10^{16}$ | $4.5\times10^{16}$ | $6.2\times10^{16}$ | $9.1\times10^{16}$ |
| Number of Impurity Atoms: $n_{ch}$ | 2.4 | 1.3 | 0.6 | 0.3 | 0.1 |
| Variation in Numbers of Impurity Atoms: $\sqrt{n}$ | 1.5 | 1.1 | 0.8 | 0.6 | 0.4 |
| $n+\sqrt{n}$ | 3.9 | 2.5 | 1.4 | 0.9 | 0.5 |
| $n-\sqrt{n}$ | 0.8 | 0.2 | 0.0 | 0.0 | 0.0 |
| $N_{SOI}^+$ [cm$^{-3}$] | $3.8\times10^{16}$ | $5.8\times10^{16}$ | $1.0\times10^{17}$ | $1.7\times10^{17}$ | $3.4\times10^{17}$ |
| $N_{SOI}^-$ [cm$^{-3}$] | $8.1\times10^{15}$ | $4.0\times10^{15}$ | 0.0 | 0.0 | 0.0 |
| $\sigma_{Vth.lacc}$ [mV] | **20.0** | **34.4** | - | - | |

As is clear from a comparison between $V_{DD, lacc}$ and $V_{DD, inv}$ in Table 4, since, in the accumulation-mode transistor, the directions of electric fields applied to the gate insulating film are opposite to each other in the on and off states of the transistor, the power supply voltage can be set higher than that of the inversion-mode transistor. This is advantageous in that the allowable value of variation in threshold values can be made slightly larger.
However, in the case where an LSI is realized with the accumulation current controlled accumulation-mode transistors shown in Table 4, the impurity atom concentration is so small that the average number of impurity atoms contained in the channel region becomes 1 or less in the miniaturized generation after the 65nm generation. As a result, the LSI includes a large number of transistors each having one impurity atom in its channel and a large number of transistors having no impurity atom in its channel so that variation in threshold values largely exceeds 1/23 of the power supply voltage.

To summarize what has been described above, in the case of the inversion-mode transistors, the requirement for variation in threshold values of the transistors in the LSI cannot be satisfied after the 45nm generation due to variation in impurity atom concentrations while, in the case of the intrinsic-mode transistors, the requirement for variation in threshold values of the transistors in the LSI cannot be satisfied in any of the generations due to the imperfection of the wafer impurity atom concentration control technique.

Further, in the case of the accumulation current controlled accumulation-mode transistors being the generally known accumulation-mode transistors, there appear the transistors each having a threshold voltage falling in an undesirable range of the transistor operating range. Accordingly, in the case of the accumulation current controlled accumulation-mode transistors, the average number of impurity atoms contained in the channel region becomes 1 or less in the 65nm or less miniaturized generation and, therefore, when realizing an LSI in the 45nm or less miniaturized generation, the requirement for variation in threshold values of the transistors in the LSI cannot be satisfied.

It is an object of this invention to provide a transistor that can suppress variation in threshold voltages to be low with respect to statistical variation in impurity atom concentrations in channel regions.

Further, it is an object of this invention to provide a transistor in which a large voltage swing can be applied to a gate electrode and which thus can increase an allowable value of variation in threshold voltages.

The present inventors have newly found that if a change in threshold voltage is made small with respect to a change in impurity atom concentration in a channel region while keeping the impurity atom concentration relatively high, it is possible to suppress variation in threshold values to be small with respect to statistical variation in impurity atom concentrations in channel regions and that, in order to achieve this, it is necessary to use a bulk current controlled accumulation-mode transistor, and have reached this invention.

Means for Solving the Problem

According to the invention, there is obtained a semiconductor device **characterized in that** variation in threshold voltages determined by statistical variation in impurity atom concentrations in channel regions does not restrict operation of an LSI in a 22nm or more generation.

In another aspect of the invention, there is obtained a semiconductor device **characterized in that** a standard deviation of variation in threshold voltages determined by statistical variation in impurity atom concentrations in channel regions is smaller than 1/23 of a power supply voltage of an LSI in a 22nm or more generation.

In other aspect of the invention, there is a bulk current controlled accumulation-mode transistor comprising a channel region and a source region and a drain region provided at both ends of the channel region, wherein the channel region is formed of an n-type semiconductor with electrons used as carriers or is formed of a p-type semiconductor with holes used as carriers, **characterized in that** the transistor has an operating range which allows to conduct the carriers only into a region, other than an interface between a gate insulating film and silicon, of the channel region.

In an embodiment, the bulk current controlled accumulation-mode transistor allows to conduct the carriers into the region, other than the interface between the gate insulating film and the silicon, of the channel region in a subthreshold range where the current that flows to the drain electrode increases exponentially with respect to an increase in the voltage applied to the gate electrode, and in the operating range including a threshold value of the transistor.

In an embodiment, the bulk current controlled accumulation-mode transistor is configured so that the channel region is formed of an SOI layer and the SOI layer has a thickness smaller than 100nm and has an impurity atom concentration higher than $2 \times 10^{17}$ [cm$^{-3}$].

In an embodiment, in the bulk current controlled accumulation-mode transistor, the source region and the drain region are formed of a semiconductor of the same conductivity type as that of the channel region.

In an embodiment, in the bulk current controlled accumulation-mode transistor, the source region and the drain region are formed of a metal or a metal-semiconductor compound having a work function with a difference of 0.32eV or less with respect to a work function of the semiconductor of the channel region.

In an embodiment, in the bulk current controlled accumulation-mode transistor, the channel region is formed of n-type silicon and the source region and the drain region are formed of a metal or a metal-semiconductor compound having a work function of -4.37eV or more.

In an embodiment, in the bulk current controlled accumulation-mode transistor, the channel region is formed of p-type silicon and the source region and the drain region are formed of a metal or a metal-semiconductor compound having a work function of -4.95eV or less.

In an embodiment, in the bulk current controlled accumulation-mode transistor, the transistor is of a normally-off type.

In an embodiment, the bulk current controlled accumulation-mode transistor is configured so that the channel region is formed of an SOI layer and the SOI layer has a thickness smaller than that of a depletion layer which is formed in a semiconductor layer at a contact portion between the channel region and the source region when a voltage applied to the drain electrode changes from 0V to a power supply voltage while a voltage applied to the gate electrode is equal to a voltage applied to the source electrode.

In one embodiment, in the bulk current controlled accumulation-mode transistor, the thickness of the SOI layer, an impurity atom concentration in the SOI layer, and a work function of the gate electrode over the channel region are determined such that the depletion layer formed in the semiconductor layer of the channel region at the contact portion between the channel region and the source region by a work function difference between the gate electrode provided on the gate insulating film and the semiconductor layer is formed continuously in a depth direction of the semiconductor layer when the voltage applied to the drain electrode changes from 0V to the power supply voltage while the voltage applied to the gate electrode is equal to the voltage applied to the source electrode. In one embodiment, in the bulk current controlled accumulation-mode transistor, the thickness of the SOI layer is 10nm or less and the impurity atom concentration in the channel region is $5 \times 10^{17}$ [cm$^{-3}$] or more.

According to an aspect of the invention, there is obtained a bulk current controlled accumulation-mode CMOS semiconductor device comprising at least two bulk current controlled accumulation-mode transistors, wherein one of the two transistors is an n-channel transistor and the other is a p-channel transistor.

In one embodiment, in the bulk current controlled accumulation-mode CMOS semiconductor device, at least a part of a channel region of each of the n-channel transistor and the p-channel transistor has a (100) plane or a plane within $\pm 10°$ from the (100) plane.

Moreover, in the bulk current controlled accumulation-mode CMOS semiconductor device, at least a part of a channel region of each of the n-channel transistor and the p-channel transistor may be formed to have a (110) plane or a plane within $\pm 10°$ from the (110) plane.

Further, in the bulk current controlled accumulation-mode CMOS semiconductor, at least a part of a channel region of the n-channel transistor has a (100) plane or a plane within $\pm 10°$ from the (100) plane and at least a part of a channel region of the p-channel transistor has a (110) plane or a plane within $\pm 10°$ from the (110) plane.

Effect of the Invention

According to this invention, since the threshold voltage is less affected by a change in impurity atom concentration in a channel region, there is an effect that variation in threshold voltages can be made small with respect to statistical variation in impurity atom concentrations even in the miniaturized generations and thus that it is possible to reduce the probability of occurrence of LSI failure which is determined by variation in threshold voltages.

Brief Description of the Drawings

Fig. 1 is a diagram showing, with respect to each of miniaturized generations L, a power supply voltage-based allowable variation value ($V_{DD, inv}/23$) and a standard deviation $\sigma_{Vth, inv}$ of variation in threshold voltages in inversion-mode transistors.

Fig. 2 is a diagram showing, with respect to each of miniaturized generations L, a power supply voltage-based allowable variation value ($V_{DD, inv}/23$) and a standard deviation $\sigma_{Vth, inv}$ of variation in threshold voltages in inversion-mode transistors and a threshold value difference $\Delta V_{th, intrinsic}$ between an intrinsic-mode transistor having no impurity atom in its channel region and an intrinsic-mode transistor having one impurity atom in its channel region.

Fig. 3 is a diagram showing that transistors with different operations are obtained when ranges are defined by the semiconductor-layer (SOI-layer) thickness $T_{SOI}$ and the SOI-layer impurity atom concentration $N_{SOI}$, wherein there are shown a range of the normally-on type represented by a zone (a), a range of the bulk current controlled type represented by a zone (b), a range of the accumulation layer current controlled type represented by a zone (c), and a range of a transistor in which the drain current does not increase exponentially with respect to the gate voltage in a threshold voltage range, represented by a zone (d).

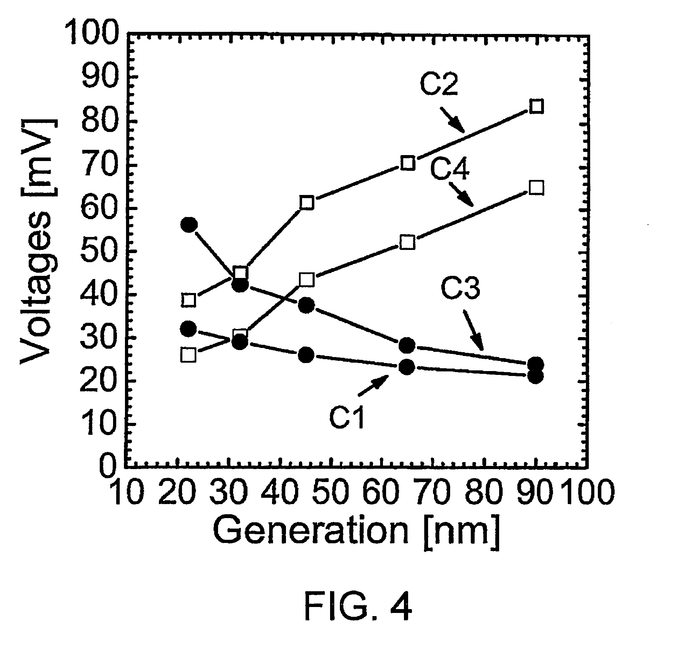

Fig. 4 is a diagram showing, with respect to the miniaturized generations L, the relationship between the power supply voltage-based allowable variation value ($V_{DD}/23$) and the standard deviation $\sigma_{Vth}$ of variation in threshold voltages in inversion-mode transistors and bulk current controlled accumulation-mode transistors.

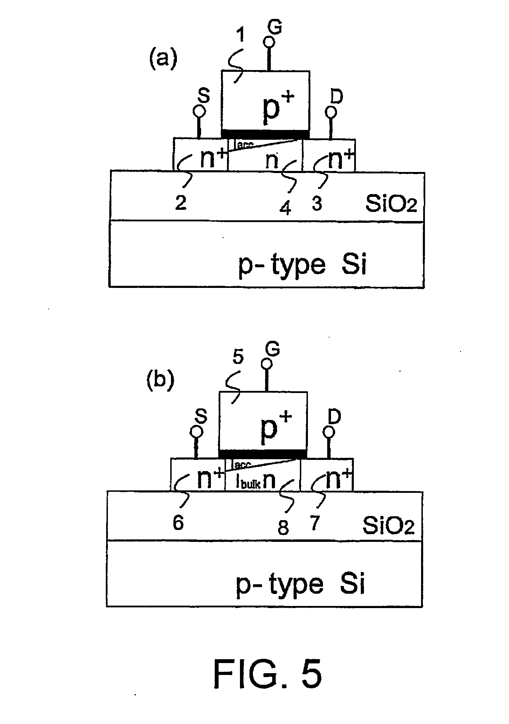

Fig. 5 is a cross-sectional view of accumulation-mode n-channel transistors, wherein (a) and (b) show an accumulation layer current controlled accumulation-mode n-channel transistor as a comparative example and a bulk current controlled accumulation-mode n-channel transistor according to an embodiment 1 of this invention, respectively.

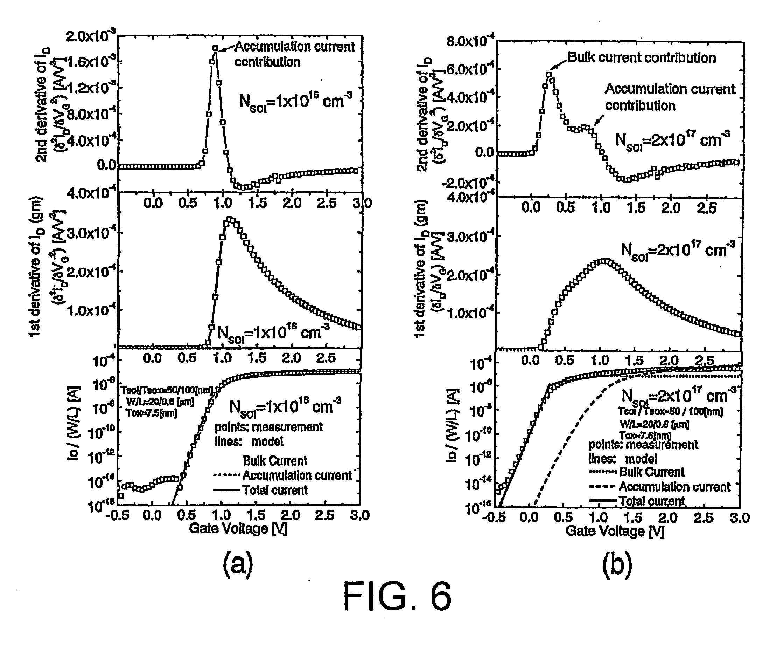

Fig. 6 is a diagram showing the transistor characteristics, wherein (a) and (b) are diagrams showing the characteristics of the accumulation layer current controlled accumulation-mode n-channel transistor and the bulk current controlled accumulation-mode transistor shown in Fig. 5 (a) and (b).

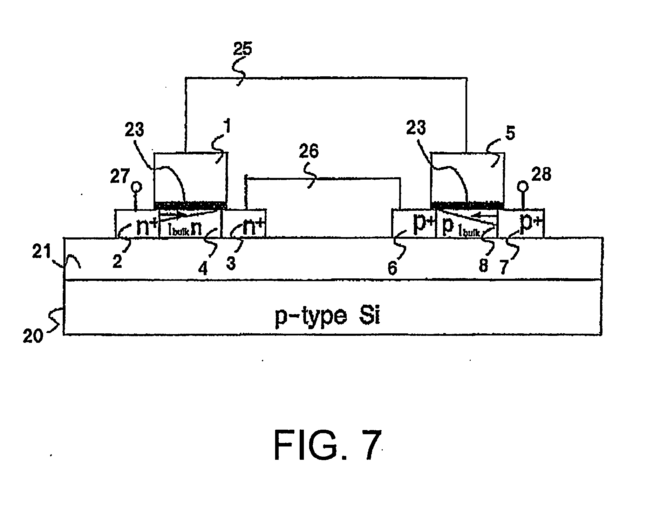

Fig. 7 is a diagram showing a bulk current controlled CMOS semiconductor device according to an embodiment 2 of this invention.

Embodiments of t the Invention

Analysis of Bulk Current Controlled Accumulation-Mode Transistor:

The threshold value of a bulk current controlled accumulation-mode transistor is the boundary from a range where the drain current increases exponentially with respect to the gate voltage to a range where the drain current does not increase exponentially with respect to the gate voltage. That is, it is the transition point between the zone b and the zone d (i.e. the range 1 and the range 2) shown in Fig. 3. Therefore, the threshold voltage of the bulk current controlled accumulation-mode transistor is a gate voltage when the thickness of a depletion layer in a silicon region becomes equal to $T_{SOI}$, and is given by the following formula (13).

[Formula 13]

$$V_{th} = V_{fb} - V_g \ (W_{dep} = T_{SOI})$$

$$= V_{fb} - qT_{SOI} \ N_{SOI} \left( \frac{1}{C_{ox}} + \frac{T_{SOI}}{2\varepsilon_{Si}} \right) \tag{13}$$

$$= \phi_m - 4.61 + \frac{Q_f}{C_{ox}} + \frac{kT}{q} l \ n \left( \frac{N_{SOI}}{n_i} \right) - qT_{SOI} \ N_{SOI} \left( \frac{1}{C_{ox}} + \frac{T_{SOI}}{2\varepsilon_{Si}} \right)$$

Herein, the fourth and fifth terms on the right side of the formula (13) are both functions of $N_{SOI}$, but change opposite to each other with respect to a change in $N_{SOI}$. This means that a change in threshold voltage of the bulk current controlled accumulation-mode transistor is small with respect to a change in $N_{SOI}$.

Table 5 shows, with respect to each of the transistor miniaturized generations, the effective channel length ($L_{eff}$), the power supply voltage of bulk current controlled accumulation-mode transistors, the electrical equivalent oxide thickness (EOT), the average threshold value, the allowable value of variation in threshold values of the bulk current controlled accumulation-mode transistors, $N_{SOI}$, $n_{channel}$, $\sqrt{n_{channel}}$, $n_{channel} + \sqrt{n_{channel}}$, $n_{channel} - \sqrt{n_{channel}}$, $N_{SOI}^+$, $N_{SOI}^-$, and the standard deviation of variation in threshold values generated by variation in impurity atom concentrations. The power supply voltage of the bulk current controlled accumulation-mode transistors is set to a value such that the strength of an electric field applied to a gate insulating film of each bulk current controlled accumulation-mode transistor does not exceed 8MV/cm.

Table 5 also shows, for comparison, the power supply voltage-based allowable variation value of the inversion-mode transistors.

In the bulk current controlled accumulation-mode transistor, the directions of electric fields applied to the gate insulating film are opposite to each other in the on and off states of the transistor and further the electric field strength can be 0MV/cm or less even when the gate voltage is equal to a threshold voltage, and therefore, the power supply voltage can be set higher than that of the accumulation current controlled accumulation-mode transistor. This is advantageous in that the allowable value of variation in threshold values can be made larger.

In fact, as shown in Table 5, the power supply voltage-based allowable variation value $\sigma$ ($=V_{DD, \ Ibulk}/23$) (mV) of the bulk current controlled accumulation-mode transistors is 83.9mV in the 90nm generation while the standard deviation $\sigma_{Vth, \ Ibulk}$ (mV) of variation in threshold values is 21.3mV. In this manner, in the 90nm miniaturized generation, the power supply voltage-based allowable variation value $\sigma$ is greater than the standard deviation of variation in threshold values. Likewise, even in the 22nm miniaturized generation, the power supply voltage-based allowable variation value $\sigma$ (38.7mV) is greater than the standard deviation 32.1 mV of variation in threshold values. Therefore, it is seen that, with the bulk current controlled accumulation-mode transistors, variation in threshold voltages determined by statistical variation in impurity atom concentrations in channel regions does not restrict the operation of an LSI in the 22nm or more generation.

[Table 5]

| | 90 | 65 | 45 | 32 | 22 |
|---|---|---|---|---|---|
| Generation L [nm] | 90 | 65 | 45 | 32 | 22 |
| $L_{eff}$ [nm] | 50 | 41 | 29 | 20 | 12 |
| $V_{DD.inv}$ [V] | **1.50** | **1.20** | **1.00** | **0.70** | **0.60** |
| $V_{DD.Ibulk}$ [V] | **1.93** | **1.63** | **1.42** | **1.04** | **0.89** |
| EOT [nm] | 1.5 | 1.2 | 1.0 | 0.7 | 0.5 |
| $V_{th}$ [V] | 0.30 | 0.30 | 0.30 | 0.25 | 0.25 |
| Allowable Variation Value: $\sigma = V_{DD.inv}/23$ [mV] | **65.2** | **52.2** | **43.5** | **30.4** | **26.1** |
| Allowable Variation Value: $\sigma = V_{DD.Ibulk}/23$ [mV] | **83.9** | **70.8** | **61.5** | **45.0** | **38.7** |
| $N_{SOI}$ [cm$^{-3}$] | $2.3\times10^{17}$ | $4.5\times10^{17}$ | $8.0\times10^{17}$ | $1.4\times10^{18}$ | $2.5\times10^{18}$ |
| Number of Impurity Atoms: $n_{ch}$ [atoms] | 23.8 | 19.2 | 11.5 | 7.2 | 3.6 |
| Variation in Numbers of Impurity Atoms: $\sqrt{n}$ [atoms] | 4.9 | 4.4 | 3.4 | 2.7 | 1.9 |
| $n+\sqrt{n}$ [atoms] | 28.7 | 23.6 | 14.9 | 9.8 | 5.5 |
| $n-\sqrt{n}$ [atoms] | 18.9 | 14.8 | 8.1 | 4.5 | 1.7 |
| $N_{SOI}^{+}$ [cm$^{-3}$] | $2.8\times10^{17}$ | $5.5\times10^{17}$ | $1.0\times10^{18}$ | $1.9\times10^{18}$ | $3.8\times10^{18}$ |
| $N_{SOI}^{-}$ [cm$^{-3}$] | $1.8\times10^{17}$ | $3.5\times10^{17}$ | $5.6\times10^{17}$ | $8.8\times10^{17}$ | $1.2\times10^{18}$ |
| $\sigma_{Vth.Ibulk}$ [mV] | **21.3** | **23.3** | **26.1** | **29.1** | **32.1** |

Referring now to Fig. 4, there are shown, with respect to the miniaturized generations L, allowable values ($V_{DD}/23$) of variation in threshold voltages and variations $\sigma_{Vth}$ in threshold voltages in the inversion-mode transistors and the bulk current controlled accumulation-mode transistors.

Specifically, in Fig. 4, the ordinate axis and the abscissa axis represent the voltage (mV) and the miniaturized generation (nm), respectively, wherein curves C1 and C2 show variations $\sigma_{Vth, Ibulk}$ in threshold voltages and power supply voltage-based allowable variation values ($V_{DD, Ibulk}/23$) of the bulk current controlled accumulation-mode transistors, respectively, while curves C3 and C4 show variations $\sigma_{Vth, inv}$ in threshold voltages and power supply voltage-based allowable variation values ($V_{DD, inv}/23$) of the inversion-mode transistors, respectively.

As is also clear from the curves C1 and C2, in the case of the bulk current controlled accumulation-mode transistors, the variation $\sigma_{Vth, Ibulk}$ in threshold voltages is smaller than the power supply voltage-based allowable variation value ($V_{DD, Ibulk}/23$) even in the 22nm generation. This means that no failure occurs due to statistical variation in impurity concentrations in channel regions even if an LSI with a trillion gates is operated for 10 years at a clock rate of 10GHz.

Further, the variation in threshold voltages of the bulk current controlled accumulation-mode transistors is smaller than the variation in threshold voltages of the inversion-mode transistors in any of the generations. This means that, using the bulk current controlled accumulation-mode transistors, it is possible to realize an LSI having more gates, an LSI that can operate at a higher speed, and an LSI that can operate for a longer period of time, without the occurrence of failure, as compared with using the inversion-mode transistors of the same generation.

Embodiment 1

Referring to Fig. 5, there is shown a bulk current controlled accumulation-mode n-channel transistor (hereinafter simply referred to as an n-channel transistor) according to an embodiment 1 of this invention along with a comparative example.

Fig. 5 (a) is the comparative example (accumulation current controlled accumulation-mode transistor), wherein an n-type Silicon on Insulator (SOI) layer (hereinafter referred to as a semiconductor layer) 4, separated by a buried oxide film having a thickness of about 100nm, is formed on a support substrate formed of p-type silicon. Herein, the semiconductor layer 4 forms a channel region and a surface of the illustrated channel region has a (100) surface orientation. The semiconductor layer 4 has a thickness of 50nm.

Further, on both sides of the semiconductor layer 4 that forms the channel region, there are provided source and drain regions 2 and 3 each formed of an n+ semiconductor having the same conductivity type as that of the channel region and having a higher impurity atom concentration than the channel region.

A gate insulating film in the form of an oxide film of 7.5nm in terms of electrical equivalent oxide thickness (EOT) is provided on the channel region formed by the semiconductor layer 4 and a gate electrode 1 of p+ polysilicon is provided on the gate insulating film. The illustrated n-channel transistor has a gate length of $0.6\mu$m and a gate width of $20.0\mu$m. Herein, the average impurity atom concentration in the channel region is $1\times10^{16}$cm$^{-3}$ (thus, this device corresponds to A in Fig. 3) and the source and drain regions 2 and 3 being in contact with the channel region are each formed of a semiconductor of $2\times10^{20}$cm$^{-3}$ and a metal-semiconductor compound. The metal-semiconductor compound is Al silicide. However, in the case of the n-channel transistor, Ni silicide, Er silicide, Y silicide, or the like may be used to suppress the contact resistance with the semiconductor to $1\times10^{-11}\Omega$cm$^2$ or less, thereby setting the series resistance of the transistor in total of the contact resistance and a series resistance of the semiconductor portion of the source/drain region to $1.0\Omega\mu$m. Further, in the case of the n-channel transistor, the source and drain layers may be formed of a metal or a metal-semiconductor compound having a work function of -4.37eV or more.

On the other hand, the bulk current controlled accumulation-mode n-channel transistor shown in Fig. 5 (b) is such that, like in Fig. 5 (a), an n-type semiconductor layer 8, separated by a buried oxide film having a thickness of about 100nm, is formed on a support substrate formed of p-type silicon. Herein, the semiconductor layer 8 forms a channel region and a surface of the illustrated channel region has a (100) surface orientation. The semiconductor layer 8 has a thickness of 50nm. On both sides of the channel region formed by the n-type semiconductor layer 8, there are provided source and drain regions 6 and 7 each formed of an n+ semiconductor having the same conductivity type as that of the channel region and having a higher impurity atom concentration than the channel region. A gate insulating film in the form of an oxide film of 7.5nm in terms of electrical equivalent oxide thickness (EOT) is provided on the channel region formed by the semiconductor layer 8 and a gate electrode 5 of p+ polysilicon is provided on the gate insulating film. Like the n-channel transistor of Fig. 5 (a), the illustrated n-channel transistor has a gate length of $0.6\mu$m and a gate width of $20.0\mu$m.

Herein, the average impurity atom concentration in the channel region is $2\times10^{17}$cm$^{-3}$ (corresponding to B in Fig. 3) and the source and drain regions 6 and 7 being in contact with the channel region are each formed of a semiconductor having an impurity concentration of $2\times10^{20}$cm$^{-3}$ and a metal-semiconductor compound. Al silicide can be used as the metal-semiconductor compound. However, Ni silicide, Er silicide, Y silicide, or the like may be used to suppress the contact resistance with the semiconductor to $1\times10^{-11}\Omega$cm$^2$ or less, thereby setting the series resistance of the transistor in total of the contact resistance and a series resistance of the semiconductor portion of the source/drain region to $1.0\Omega\mu$m. The source and drain layers may be formed of a metal or a metal-semiconductor compound having a work function of -4.37eV or more, which is the same as in Fig. 5 (a).

The above is the examples of the n-channel transistors, but these transistors may alternatively be p-channel transistors.

In the case of the p-channel transistor, source and drain electrodes may be formed of Pd silicide or Pt silicide to suppress the contact resistance with a semiconductor to $1\times10^{-11}\Omega$cm$^2$ or less, thereby setting the series resistance of the transistor in total of the contact resistance and a series resistance of the semiconductor portion of the source/drain region to $1.0\Omega\mu$m. In the case of the p-channel transistor, the source and drain regions 6 and 7 may be formed of a metal or a metal-semiconductor compound having a work function of -4.95eV or less.

At any rate, the material of the source and drain regions is selected so that the difference between the work function of the source and drain regions and the work function of the semiconductor layer of the channel region in the transistor shown in Fig. 5 (b) becomes 0.32eV or less.

In the n-channel transistor shown in Fig. 5 (a) or (b), when the voltage applied to a drain electrode D changes from 0V to a power supply voltage while the voltage applied to the gate electrode 1 or 5 is equal to a voltage applied to a source electrode S, the thickness of a depletion layer formed in the semiconductor layer of the channel region at a contact portion between the channel region and the source region is greater than 50nm so that normally-off is realized.

Referring to Fig. 6 (a) and (b), there are shown the characteristics of the n-channel transistors shown in Fig. 5 (a) and (b), respectively. Fig. 6 (a) and (b) each show, from the top in order, the relationship between the drain current and the gate voltage and the relationships between the first and second derivatives of the drain current and the gate voltage when the drain voltage is 50mV in the n-channel transistor. Further, in the lowermost column in each of Fig. 6 (a) and (b), there are shown $I_{acc}$ and $I_{bulk}$ obtained from the formulas (9) to (11) and calculated values of $I_{total}$ being the sum total of $I_{acc}$ and $I_{bulk}$.

Herein, the threshold voltage is a gate voltage when a drain current of $1\mu$A, normalized by W/L, flows. It is 1.05V in (a) and 0.28V in (b). Since (a) is the accumulation layer current controlled accumulation-mode transistor, $I_{acc}$ is the main component of the drain current in the threshold voltage range. On the other hand, in the bulk current controlled accumulation-mode transistor according to this invention of (b), $I_{bulk}$ is the main component of the drain current in the threshold voltage range.

Further, as shown in the upper diagrams of Fig. 6, in the second derivatives of the drain current with respect to the gate voltage, only one peak is observed corresponding to an increase in $I_{acc}$ in (a) while two peaks are observed in (b) corresponding to an increase in $I_{bulk}$ in the vicinity of the threshold voltage range and corresponding to an increase in $I_{acc}$ in a range where the gate voltage is greater than the threshold voltage.

In the bulk current controlled transistor shown in Fig. 5 (b), the thickness $T_{SOI}$ of the semiconductor layer 8, the impurity atom concentration $N_{SOI}$ in the semiconductor layer 8, and the work function of the gate electrode 5 are determined such that the depletion layer formed in the semiconductor layer 8 of the channel region at the contact portion between the channel region and the source region 6 by a work function difference between the gate electrode 5 provided on the gate insulating film and the semiconductor layer 8 of the channel region is formed continuously in a depth direction of the semiconductor layer when the voltage applied to the drain electrode D changes from 0V to the power supply voltage while the voltage applied to the gate electrode G is equal to the voltage applied to the source electrode S.

In the embodiment shown in Fig. 5 (b), the example is shown where the thickness of the semiconductor layer 8 forming the channel region is 50nm and the impurity atom concentration thereof is $2 \times 10^{17} cm^{-3}$. However, as is also clear from the zone b in Fig. 3, if the thickness $T_{SOI}$ of the semiconductor layer 8 is reduced, the impurity atom concentration $N_{SOI}$ is increased. For example, if the thickness $T_{SOI}$ of the semiconductor layer 8 is 10nm or less, the impurity atom concentration $N_{SOI}$ is set to $5 \times 10^{17} cm^{-3}$ or more.

In the above description, the description has been given of the case where the semiconductor (SOI) layer is the (100) surface orientation, but the effects equivalent to those described above are obtained in the case of any surface orientation. For example, at least a part of the channel region may have a plane within $\pm 10°$ from the (100) plane or may have a (110) plane or a plane within $\pm 10°$ from the (110) plane.

Embodiment 2

Referring to Fig. 7, a bulk current controlled CMOS semiconductor device according to an embodiment 2 of this invention will be described. The illustrated bulk current controlled CMOS semiconductor device comprises n-channel and p-channel transistors. The illustrated bulk current controlled CMOS semiconductor device is such that a semiconductor (SOI) layer, separated by a buried oxide film 21 having a thickness of 100nm, is formed on a support substrate 20.

In the case of this example, the semiconductor layer is an n-type semiconductor layer having a (551) surface orientation inclined by 8° from the (110) surface orientation and is separated, by etching, into a portion which will be the n-channel transistor and a portion which be the p-channel transistor. Then, for impurity atom concentration adjustment, phosphorus is implanted into the portion, which will be the n-channel transistor, of the semiconductor layer while boron is implanted into the portion, which will be the p-channel transistor, of the semiconductor layer. By this, threshold values of the n-channel transistor and the p-channel transistor are adjusted. In this example, the thickness ($T_{SOI}$) and the impurity atom concentration ($N_{SOI}$) of the semiconductor layer are adjusted so that the threshold value of each transistor falls in the zone b in Fig. 3, thereby forming semiconductor layers 4 and 8 of channel regions. For example, the impurity atom concentration in the channel region 4 of the n-channel transistor is $3 \times 10^{18} cm^{-3}$ and the impurity atom concentration in the channel region 8 of the p-channel transistor is $3 \times 10^{18} cm^{-3}$.

Then, using a microwave-excited plasma apparatus, $Si_3N_4$ films of 1 nm in terms of an electrical oxide film equivalent insulating film thickness are formed on surfaces of the channel regions 4 and 8 of the transistors, respectively, thereby forming gate insulating films 23. Herein, the surfaces of the channel regions have been subjected to a flattening process so as to have a peak-to-valley of 0.16nm or less and thus the interfaces between the gate insulating films 23 and the channel regions are extremely flat on the atomic order. As the gate insulating film 23, use may be made of a high permittivity material, such as a metal oxide such as $SiO_2$, $HfO_x$, $ZrO_x$, or $La_2O_3$, or a metal nitride such as $Pr_xSiyN_z$.

Thereafter, a Ta film is formed on the gate insulating films 23 and then etched to a desired gate length and width, thereby forming gate electrodes 1 and 5. In this event, since the semiconductor layers 4 and 8 are each fully depleted due to the formation of a depletion layer with a thickness of about 18nm by a work function difference between the channel region 4, 8 and the gate electrode 1, 5, the n-channel transistor and the p-channel transistor are both normally off.

Thereafter, arsenic is implanted into source and drain layers of the n-channel transistor region to perform activation, thereby forming a source region 2 and a drain region 3 each having an impurity atom concentration of $2 \times 10^{20} cm^{-3}$, while boron is implanted into source and drain layers of the p-channel transistor region to perform activation, thereby forming a source region 6 and a drain region 7 each having an impurity atom concentration of $2 \times 10^{20} cm^{-3}$.

Further, as wiring layers, a gate line 25, an output line 26, and power supply lines 27 and 28 are formed.

The above-mentioned CMOS semiconductor device may be fabricated on a surface orientation other than the (551) surface orientation. For example, it may be fabricated on an SOI layer of the (100) surface orientation.

Industrial Applicability

According to this invention, the description has been given of bulk current controlled accumulation-mode n-channel and p-channel transistors in which the thickness of a semiconductor layer (SOI layer) is smaller than 100nm and the substrate concentration is higher than $2 \times 10^{17}$ [$cm^{-3}$], and a CMOS circuit comprising these transistors. However, this invention is not limited thereto and can also be applied to various elements and electronic circuits.

**Claims**

1. A semiconductor device **characterized in that** variation in threshold voltages determined by statistical variation in impurity atom concentrations in channel regions does not restrict operation of an LSI in a 22nm or more miniaturized generation.

2. A semiconductor device **characterized in that** a standard deviation of variation in threshold voltages determined by statistical variation in impurity atom concentrations in channel regions is smaller than 1/23 of a power supply voltage of an LSI in a 22nm or more miniaturized generation.

3. A bulk current controlled accumulation-mode transistor comprising a channel region and a source region and a drain region provided at both ends of the channel region, wherein the channel region is formed of an n-type semiconductor with electrons used as carriers or is formed of a p-type semiconductor with holes used as carriers, **characterized in that** the transistor has an operating range which allows to conduct the carriers only into a region, other than an interface between a gate insulating film and silicon, of the channel region and which allows to control, by two digits or more, a current that flows to a drain electrode by a voltage applied to a gate electrode.

4. The bulk current controlled accumulation-mode transistor according to claim 3, **characterized by** allowing to conduct the carriers into the region, other than the interface between the gate insulating film and the silicon, of the channel region in a subthreshold range where the current that flows to the drain electrode increases exponentially with respect to an increase in the voltage applied to the gate electrode, and in the operating range including a threshold value of the transistor.

5. The bulk current controlled accumulation-mode transistor according to claim 4, **characterized in that** the channel region is formed of an SOI layer and the SOI layer has a thickness smaller than 100nm and has an impurity atom concentration higher than $2 \times 10^{17}$ [cm$^{-3}$].

6. The bulk current controlled accumulation-mode transistor according to any one of claims 3 to 5, **characterized in that** the source region and the drain region are formed of a semiconductor of the same conductivity type as that of the channel region.

7. The bulk current controlled accumulation-mode transistor according to any one of claims 3 to 5, **characterized in that** the source region and the drain region are formed of a metal or a metal-semiconductor compound having a work function with a difference of 0.32eV or less with respect to a work function of the semiconductor of the channel region.

8. The bulk current controlled accumulation-mode transistor according to claim 7, **characterized in that** the channel region is formed of n-type silicon and the source region and the drain region are formed of a metal or a metal-semiconductor compound having a work function of -4.37eV or more.

9. The bulk current controlled accumulation-mode transistor according to claim 7, **characterized in that** the channel region is formed of p-type silicon and the source region and the drain region are formed of a metal or a metal-semiconductor compound having a work function of -4.95eV or less.

10. The bulk current controlled accumulation-mode transistor according to any one of claims 3 to 9, **characterized in that** the transistor is of a normally-off type.

11. The bulk current controlled accumulation-mode transistor according to claim 10, **characterized in that** the channel region is formed of an SOI layer and the SOI layer has a thickness smaller than that of a depletion layer which is formed in a semiconductor layer at a contact portion between the channel region and the source region when a voltage applied to the drain electrode changes from 0V to a power supply voltage while a voltage applied to the gate electrode is equal to a voltage applied to the source electrode.

12. The bulk current controlled accumulation-mode transistor according to claim 11, **characterized in that** the thickness of the SOI layer, an impurity atom concentration in the SOI layer, and a work function of the gate electrode over the channel region are determined such that the depletion layer formed in the semiconductor layer of the channel region at the contact portion between the channel region and the source region by a work function difference between the gate electrode provided on the gate insulating film and the semiconductor layer is formed continuously in a depth direction of the semiconductor layer when the voltage applied to the drain electrode changes from 0V to the power supply voltage while the voltage applied to the gate electrode is equal to the voltage applied to the source electrode.

13. The bulk current controlled accumulation-mode transistor according to any one of claims 3 to 12, **characterized in that** the thickness of the SOI layer is 10nm or less and the impurity atom concentration in the channel region is $5 \times 10^{17}$ [cm$^{-3}$] or more.

14. A bulk current controlled accumulation-mode CMOS semiconductor device **characterized by** comprising at least two transistors each according to any one of claims 3 to 13, wherein one of the two transistors is an n-channel transistor and the other is a p-channel transistor.

15. The bulk current controlled accumulation-mode CMOS semiconductor device according to claim 14, **characterized in that** at least a part of a channel region of each of the n-channel transistor and the p-channel transistor has a (100) plane or a plane within $\pm 10°$ from the (100) plane.

16. The bulk current controlled accumulation-mode CMOS semiconductor device according to claim 14, **characterized in that** at least a part of a channel region of each of the n-channel transistor and the p-channel transistor has a (110) plane or a plane within $\pm 10°$ from the (110) plane.

17. The bulk current controlled accumulation-mode CMOS semiconductor device according to claim 14, **characterized in that** at least a part of a channel region of the n-channel transistor has a (100) plane or a plane within $\pm 10°$ from the (100) plane and at least a part of a channel region of the p-channel transistor has a (110) plane or a plane within $\pm 10°$ from the (110) plane.

FIG. 1

FIG. 2

FIG. 3

FIG. 4

FIG. 5

FIG. 6

FIG. 7

EP 2 284 901 A1

**INTERNATIONAL SEARCH REPORT**

| International application No. |
| --- |
| PCT/JP2009/057310 |

A.  CLASSIFICATION OF SUBJECT MATTER
*H01L29/786*(2006.01)i, *H01L21/8238*(2006.01)i, *H01L27/08*(2006.01)i,
*H01L27/092*(2006.01)i

According to International Patent Classification (IPC) or to both national classification and IPC

B.  FIELDS SEARCHED

Minimum documentation searched (classification system followed by classification symbols)
H01L29/786, H01L21/8238, H01L27/08, H01L27/092

Documentation searched other than minimum documentation to the extent that such documents are included in the fields searched
Jitsuyo Shinan Koho        1922-1996    Jitsuyo Shinan Toroku Koho    1996-2009
Kokai Jitsuyo Shinan Koho   1971-2009    Toroku Jitsuyo Shinan Koho    1994-2009

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| X | JP 2004-146550 A  (Oki Electric Industry Co., Ltd.),<br>20 May, 2004 (20.05.04),<br>Par. Nos. [0007] to [0059]<br>& US 2004/0079997 A1 | 1 |

☐  Further documents are listed in the continuation of Box C.          ☐   See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>06 July, 2009 (06.07.09) | Date of mailing of the international search report<br>14 July, 2009 (14.07.09) |
| --- | --- |
| Name and mailing address of the ISA/<br>　Japanese Patent Office | Authorized officer |
| Facsimile No. | Telephone No. |

Form PCT/ISA/210 (second sheet) (April 2007)

<table>
<tr><td><strong>INTERNATIONAL SEARCH REPORT</strong></td><td>International application No.<br>PCT/JP2009/057310</td></tr>
</table>

**Box No. II**     **Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III**     **Observations where unity of invention is lacking (Continuation of item 3 of first sheet)**

This International Searching Authority found multiple inventions in this international application, as follows:
  As described in the "extra sheet", three inventions are described in the claims of this international patent application.

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.:
   Claim 1.

**Remark on Protest**      ☐ The additional search fees were accompanied by the applicant's protest and, where applicable,
the                                payment of a protest fee.

                              ☐ The additional search fees were accompanied by the applicant's protest but the applicable protest
                                fee was not paid within the time limit specified in the invitation.

                              ☐ No protest accompanied the payment of additional search fees.

Form PCT/ISA/210 (continuation of first sheet (2)) (April 2007)

| INTERNATIONAL SEARCH REPORT | International application No. |
| --- | --- |
| | PCT/JP2009/057310 |

Continuation of Box No.III of continuation of first sheet(2)

In order that a group of inventions described in claims complies with the requirement of unity of invention, the existence of special technical features is needed for making the group of inventions so relative as to form a single general inventive concept. However, there exists no matter common to all the inventions of independent claims 1, 2 and 3.

Thus, one group of inventions of claims 1 - 17 does not have any special technical feature that is so linked as to form a single general inventive concept.

Hence, one group of inventions of claims 1 - 17 does not comply with the requirement of unity of invention.

Next, the investigation is made on the number of groups of the inventions described in the claims of this international patent application, that is, the number of inventions which are so linked as to form a general inventive concept.

The group of inventions of claims 1 - 17 does not have any special technical feature that links the group of inventions as to form a single general inventive concept, as described hereinbefore.

Thus, the claims of this international patent application describe at least three inventions, which are classified into claim 1, claim 2 and claims 3 - 17.

Form PCT/ISA/210 (extra sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2008007749 A1

**Non-patent literature cited in the description**

- **T. Ohmi ; M. Hirayama ; A. Teramoto.** New era of silicon technologies due to radical reaction based semiconductor manufacturing. *J. Phys., D, Appl. Phys.,* 2006, vol. 39, R1-R17